# EUROPEAN PATENT APPLICATION

(11) **EP 4 415 031 A1**
(43) Date of publication of application: **14.08.2024**
(21) Application number: 23155542.6
(22) Date of filing: 08.02.2023
(51) Int. Cl.: H01L 21/56, H01L 23/00

(54) **A SEMICONDUCTOR TRANSISTOR PACKAGE COMPRISING ELECTRICAL CONTACT LAYERS AND A METHOD FOR FABRICATING THE SAME**

(71) Applicant: Infineon Technologies Austria AG, 9500 Villach (AT)
(72) Inventor: FUERGUT, Edward, 86453 Dasing (DE); MEYER, Thorsten, 93053 Regensburg (DE); SCHOLZ, Wolfgang, 82140 Olching (DE); ZUDOCK, Frank, 93161 Sinzing (DE); ROTH, Alexander, 93197 Zeitlarn (DE)
(74) Representative: Lambsdorff & Lange Patentanwälte Partnerschaft mbB

(57) **Abstract**

A method (100) for fabricating a semiconductor package comprises providing a die carrier (110), disposing a semiconductor die on the die carrier, the semiconductor die comprising one or more contact pads on a first main face thereof (120), applying an encapsulant at least partially to the semiconductor die, the encapsulant embedding at least one electrical connector, the electrical connector being connected with a contact pad or with the die carrier and extending to a main face of the encapsulant (130), and depositing at least one electrical layer onto the main face of the encapsulant and an exposed end of the at least one electrical connector (140).

## Description

### TECHNICAL FIELD

The present disclosure is related in general to semiconductor devices, in particular to semiconductor power devices. The present disclosure is in particular related to a method for fabricating a semiconductor package, to a method for fabricating a semiconductor device, to a semiconductor package and to a semiconductor device.

### BACKGROUND

Chip embedding is a solution where an active or passive component is positioned in an opening of a core layer of a package carrier, in particular a printed circuit board (PCB). Until recently, this technology was commonly used for low voltage systems, in particular to apply embedding for power circuits with low voltages <100V. For high voltages special challenges are to be expected in connection with the high electric fields. The motivations for embedding high voltage semiconductor packages are manifold, e.g. increasing power density, extreme low parasitic inductances, better EMI shielding, and also high reliability and high power cycling robustness.

For embedding of high voltage applications into a PCB, the semiconductor die has to be protected by a prepackage, also called inlay, which can then be embedded in a package carrier. The protection shall avoid mechanical damage, provide large electrical contact areas for the laser drilled via connections in the PCB and has to avoid contact of the semiconductor die with the not optimal laminate material during operation (e.g. high ion content of laminate). The inlay itself should have standardized dimensions in order to fit in any package carrier at low cost. In general, the inlay of the present disclosure itself should be fabricated on a low cost basis in order to be a successful alternative to previous options. In this respect, the currently practiced fabrication of the inlay is disadvantageous as it usually involves the fabrication of electrical interconnects using costly chemical plating, in particular electroplating.

For these and other reasons there is a need for the present disclosure.

### SUMMARY

A first aspect of the present disclosure is related to a method for fabricating a semiconductor package, providing a die carrier, disposing a semiconductor die on the die carrier, the semiconductor die comprising one or more contact pads on a first main face thereof, applying at least one electrical connector to each one of the contact pads, applying an encapsulant at least partially to the semiconductor die and to the die carrier so that the at least one electrical connector extends to a main face of the encapsulant, and depositing at least one electrical layer onto the main face of the encapsulant and an exposed end of the at least one electrical connector.

One aspect of the fabrication of the semiconductor package is the provision of electrical layers as large as possible serving also as stop layers for laser drilling. Cost efficient fabricating of these layers is an important aspect of the whole process and often responsible for a high part of the overall packaging cost. The present disclosure proposes a low cost version of fabricating of the inlay, where especially low cost of the provision of the electrical layers is targeted. Printing or dispensing electrical layers is in general known to be a cost efficient method of depositing layers.

Another aspect of the semiconductor package fabricated according to the present disclosure, is that it allows high voltage testing of the semiconductor die contained therein. Therefore it is possible that only packages with functional dies (KGD, known good dies) are further processes for chip embedding. This is especially interesting for complicated multiple chip application boards.

According to an embodiment of the method according to the first aspect, depositing the electrical layer comprises printing or dispensing a layer comprising a sinter paste or a hybrid sinter paste and subsequent curing of the layer.

Printing and dispersing are already cost-effective deposition processes. According to above mentioned embodiment, the deposition process can be made all the more cost-effective by having the electrical layers thus deposited contain a sintering material, in particular a sintering paste or a hybrid sintering paste, a solder material, especially a high-melting solder material, a glue material, or any other paste material.

According to an embodiment of the method according to the first aspect, the at least one electrical connector comprises one or more of a bond wire, a bond wire loop, a vertical wire, a metallic pillar, a copper pillar, or a stud bump.

According to an embodiment of the method according to the first aspect, a thickness of the at least one electrical layer is in a range from 1 µm to 50 µm. In this context, it should be mentioned that the smallest possible layer thickness is advantageous for the subsequent embedding of the inlay in a PCB, since a surface topology of the inlay is generally undesirable for the application of a laminate layer to be carried out in this process. According to a further embodiment, however, the depositing of the electrical layer onto the encapsulant can be carried in such a way that the electrical layer is at least in part embedded in the encapsulant.

According to an embodiment of the method according to the first aspect, at least two electrical connectors are connected with one or more of a contact pad or with the die carrier and extending to a main face of the encapsulant, wherein the exposed ends of the electrical connectors are spaced from each other for more than 0.5 mm or more than 1 mm.

According to an embodiment of the method according to the first aspect, at least one electrical layer comprises an extension of more than 1 mm, 2 mm or 3 mm along at least one direction. According to an example thereof the at least one electrical layer has an extension of more than 1 mm, 2 mm or 3 mm along a direction along which the exposed ends of the electrical conductors are spaced apart from each other.

According to an embodiment of the method according to the first aspect, the semiconductor die comprises a vertical structure comprising a source pad on the first main face and a drain pad on a second main face opposite to the first main face, wherein the electrical connectors comprise first and second electrical connectors, wherein a first electrical connector is connected with the source pad and a second electrical connector is connected with the die carrier. According to an example thereof, the semiconductor die comprises one or more of a semiconductor power transistor, an IGBT die, a SiC-MOS transistor, a GaN transistor, or a CoolMOS transistor.

According to an embodiment of the method according to the first aspect, the semiconductor die comprises a gate pad on the first main face, wherein the electrical connectors comprise a third electrical connector which is connected with the gate pad. According to an example thereof, the gate pad is not directly connected with the third electrical connector but instead with a lead which itself is connected with the third electrical connector. An example thereof will be shown and described in more detail below.

A second aspect of the present disclosure is related to a method for fabricating a semiconductor device, the method comprising providing a package carrier comprising a core layer comprising an opening, and disposing the semiconductor package fabricated according to the first aspect in the opening.

According to an embodiment of the method according to the second aspect, the method further comprises applying a laminate layer to the package carrier, drilling holes through the laminate layer to the electrical layers, and filling the through holes with an electrically conductive material. According to an example thereof, drilling the holes can be done by laser drilling.

A third aspect of the present disclosure is related to a semiconductor package comprising a die carrier, a semiconductor die disposed on the die carrier, the semiconductor die comprising one or more contact pads on a first main face thereof, an encapsulant applied at least partially to the semiconductor die, the encapsulant embedding at least one electrical connector, the electrical connector being connected with a contact pad or with the die carrier and extending to a main face of the encapsulant, at least one electrical layer disposed on the main face of the encapsulant and an exposed end of the at least one electrical connector.

Embodiments of the semiconductor package according to the third aspect can be formed along the embodiments of the method for fabricating the semiconductor package according to the first aspect.

A forth aspect of the present disclosure is related to a semiconductor device comprising a package carrier comprising a core layer comprising an opening, and a semiconductor package according to the third aspect disposed in the opening.

Embodiments of the semiconductor device according to the forth aspect can be formed along the embodiments of the method for fabricating the semiconductor device according to the third aspect.

A fifth aspect of the present disclosure is related to a method for fabricating a plurality of semiconductor packages, comprising providing a panel comprising a plurality of interconnected die carriers, disposing a plurality of semiconductor dies on the die carriers, the semiconductor die each comprising one or more contact pads on a first main face thereof, applying at least one electrical connector to each one of the contact pads of the semiconductor dies, singulating the panel into a plurality of intermediate products along separation lines between the die carriers, disposing the intermediate products on a temporary carrier, fabricating a plurality of semiconductor packages by applying an encapsulant at least partially to the semiconductor dies and to the die carriers so that the at least one electrical connector extends to a main face of the encapsulant of the semiconductor packages, depositing at least one electrical layer onto the main face of the encapsulant and an exposed end of the at least one electrical connector of the semiconductor packages, separating the semiconductor packages from each other, and removing the temporary carrier.

According to an embodiment of the method according to the fifth aspect, the method can be carried out with any feature described above and below in connection with the method according to the first aspect.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows a flow diagram illustrating an example of a method for fabricating a semiconductor package according to the first aspect.
Fig. 2 comprises Fig. 2A to 2H and shows cross-sectional side views for illustrating an example of a method for fabricating a semiconductor package according to the first aspect.
Fig. 3 comprises Fig. 3A and 3B and shows cross-sectional side views of examples of a semiconductor package according to the third aspect, the first example (A) fabricated by the method of Fig. 2 and corresponding to Fig. 2H, and the second example (B) corresponding to an end product of another fabrication process.
Fig. 4 shows a cross-sectional side view of an example of a semiconductor device according to the forth aspect.
Fig. 5 comprises Fig. 5A to 5J and shows cross-sectional side views for illustrating an example of a method for fabricating a plurality of semiconductor packages according to the second aspect in which example the electrical connectors are applied after placing the semiconductor dies on the die carrier.
Fig. 6 comprises Fig. 6A to 6I and shows cross-sectional side views for illustrating an example of a method for fabricating a plurality of semiconductor packages according to the second aspect in which example the electrical connectors are applied after placing the intermediate products on the temporary carrier.
Fig. 7 shows a cross-sectional side view of a semiconductor package fabricated by either one of the method of Fig. 5 or the method of Fig. 6.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

Moreover, the word "exemplary" is used herein to mean serving as an example, instance, or illustration. Any aspect or design described herein as "exemplary" is not necessarily to be construed as advantageous over other aspects or designs. Rather, use of the word exemplary is intended to present concepts in a concrete fashion. As used in this application, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims may generally be construed to mean "one or multiple" unless specified otherwise or clear from context to be directed to a singular form. Also, at least one of A and B or the like generally means A or B or both A and B.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

### DETAILED DESCRIPTION

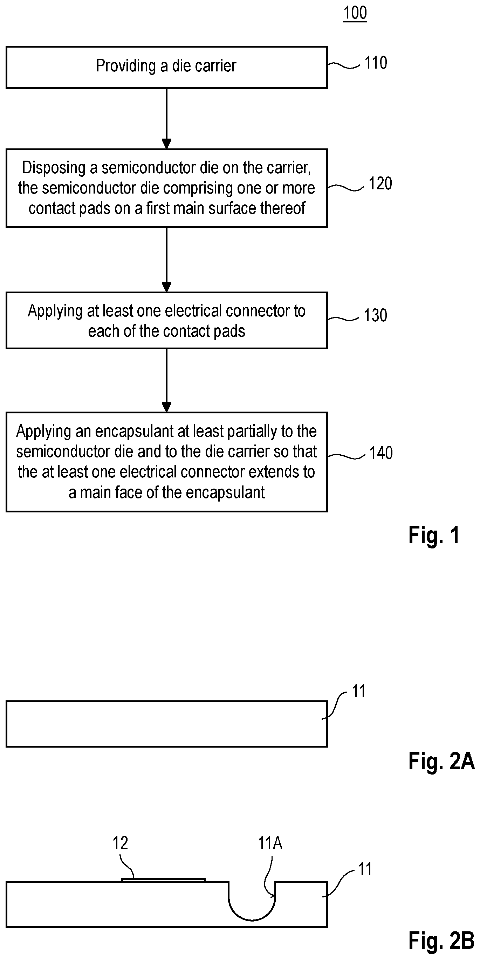

Fig. 1 shows a flow diagram illustrating an example of a method for fabricating a semiconductor package according to the first aspect.

The method 100 of Fig. 1 comprises providing a die carrier (110), disposing a semiconductor die on the die carrier, the semiconductor die comprising one or more contact pads on a first main face thereof (120), applying an encapsulant at least partially to the semiconductor die, the encapsulant embedding at least one electrical connector, the electrical connector being connected with a contact pad or with the die carrier and extending to a main face of the encapsulant (130), and printing or dispensing at least one electrical layer onto the main face of the encapsulant and an exposed end of the at least one electrical connector (140).

For the fabrication of the inlay according to the present disclosure, two possible ways are available. Either the leadframe is purchased from an external vendor (fully etched or stamped), then standard process steps are used. Or the package is generated according to a process flow, where top side and bottom side etch are separated. The process flow of Figs. 2A to 2H indicates this variant, the figure at the end also shows a potential solution with standard leadframe and process flow. A very thick copper leadframe is targeted for the inlay for thermal reason. Also, it is a target of the present disclosure to provide an inlay, which does not contain any material with low temperature stability in order to avoid any reliability issues. All interconnects are diffusion soldered or direct copper interconnects. The conductivity of a pressure sintered layer may be lower than the one of a bulk material, but due to the thin layer thickness, the impact is low.

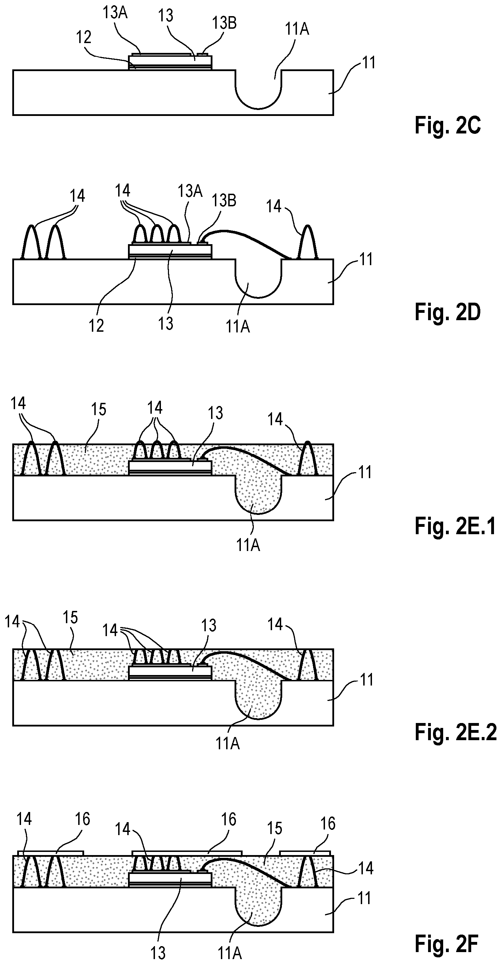

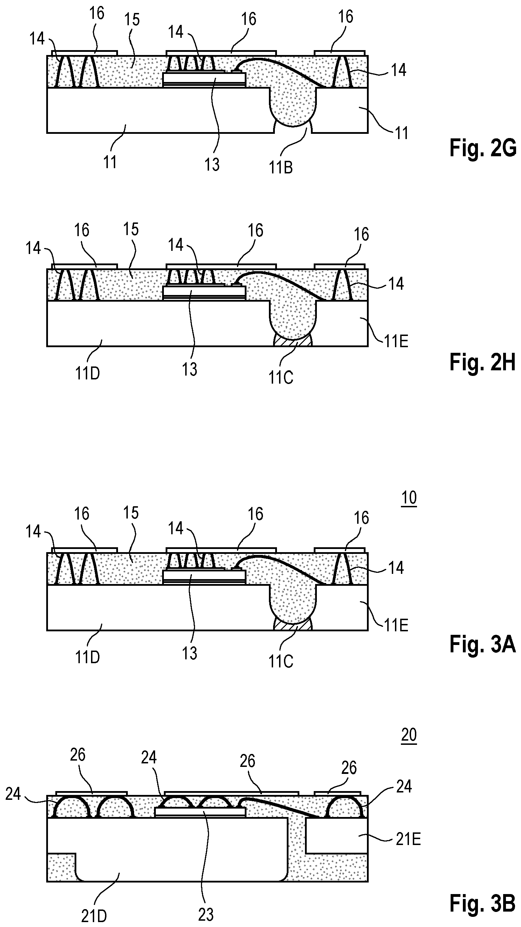

Fig. 2 comprises Fig. 2A to 2H and shows cross-sectional side views for illustrating the MPPL variant as an example of a method for fabricating a semiconductor package according to the first aspect.

Fig. 2A illustrates the first step of providing a die carrier 11. The die carrier 11 can, for example, be a copper sheet, more specifically as being part of a lead frame. The copper sheet can have a thickness in a range from 100 µm to 2000 µm.

The die carrier 11 can also be one of a direct copper bond (DCB), an active metal braze (AMB), or an isolated metal substrate (IMS).

Fig. 2B illustrates the subsequent step of applying a layer 12 which is adapted for subsequent attaching of a semiconductor die 13 to the die carrier 11. The semiconductor die 13 can be attached to the die carrier 11 by soldering, in particular diffusion soldering, in which case the layer 12 can, for example, be a part of the semiconductor die as a backside metallization or of the carrier. The layer 12 can be an NiNiP layer 12. The semiconductor die 13 can also be attached by sintering in which case the layer 12 can be a sinter layer, or by gluing in which case the layer 12 can be a glue layer, in particular a layer comprising a conductive glue like silver glue. The lateral size of the layer 12 can be adapted to the lateral size of the semiconductor die 13 to be connected.

Also illustrated in Fig. 2B is the forming of a recess 11A into an upper layer of the die carrier 11, in particular by etching. The recess 11A will later serve as part of a spatial separation between a left hand part and a right hand part of the die carrier 11. The right hand part of the die carrier 11 will then be converted into a gate contact.

Fig. 2C illustrates the subsequent step of attaching, in particular diffusion soldering, of a semiconductor transistor die 13 onto the layer 12.

The semiconductor transistor die 13 can be one or more of a vertical transistor die, a MOSFET die, an IGBT die, a SiC-MOS die, a Cool-MOS die, or an S-FET die. Furthermore the semiconductor die 13 can be one or more of a Si die, a wide bandgap semiconductor die, a SiC die, or a GaN die.

The semiconductor transistor die 12 can be configured as a discrete power transistor. A discrete power transistor is a switching device that is rated to accommodate voltages of at least 100 V (volts) and more commonly on the order of 600 V, 1200V, 2000V, 3300V or more and/or is rated to accommodate currents of at least 1A (amperes) and more commonly on the order of 10A, 50A, 100A, 1000A or more. Exemplary device types of discrete power transistors include MOSFETs (Metal Oxide Semiconductor Field Effect Transistors), IGBTs (Insulated Gate Bipolar Transistors), for example.

The semiconductor die 13 can comprise a source pad 13A, a gate pad 13B on an upper main face, and a drain pad on a lower main face.

Fig. 2D illustrates the subsequent step of attaching electrical connectors 14 to an upper main face of the die pad 11, to the source pad 13A and the gate pad 13B. The electrical connectors 14 are comprised of wire loops 14. In the present embodiment, two wire loops 14 are connected to the upper main face of the die carrier 11, three wire loops 14 are connected to the source pad 13A, and one wire loop 14 is connected to the right hand part of the die carrier 11 which itself is connected by a bond wire to the gate pad. Besides that, the number of electrical connectors 14 connected with each one of the die pad, the source pad or the gate pad can be one, two, three or even more than three. If two or more than two electrical connectors 14 are used, their upper tips can be spaced from each other for a distance of more than 0.5 mm or more than 1 mm. This allows standard external contact layouts independent from the chip layout.

The electrical connectors 14 can also comprise one or more of a single bond wire, a vertical wire, a metallic pillar, a copper pillar, or a stud bump.

Fig. 2E illustrates the subsequent step of applying an encapsulant 15 to the die carrier 11 and the semiconductor die 13. The encapsulant 15 comprises one or more of a resin, an epoxy resin, a polyimide, and a silicone. The encapsulant 13 may contain filler materials like filler particles with which the thermal conductivity may be increased. In particular, the type of material of the encapsulant 15 can be selected according to the properties of the semiconductor die 13, in particular, the voltage range of the semiconductor die 12. It is therefore possible to employ semiconductor dies with voltages above 100V by choosing an appropriate encapsulant material with sufficient isolation properties. The encapsulant 15 can be applied in different aggregate states as, for example, in liquid form, as pellets, as a granulate, or as a laminate of any kind of plastic material. Moreover, the encapsulant 15 can be made of a thermally conductive material to allow efficient heat dissipation in particular to the bottom. The material of the encapsulant 15 can, in particular, comprise a resin like epoxy resin, and more specifically a material filled with thermally conductive particles like, for example, made of AlO, BNi, AlNi, SiN, diamond, or any other thermally conductive particles.

The encapsulant 15 can be deposited by means of one or more of, for example, transfer molding, compression molding, MAP molding, panel molding, or by lamination. The encapsulant 15 is also filled into the recess 11A of the die pad 11.

The encapsulant 15 will be applied so that upper ends of the wire loops 14 are exposed. This can be done in the following two different ways.

Fig. 2E.1 illustrates the outcome of a first variant in which the encapsulant 15 is applied by film-assisted molding by which then tips of the wire loops 14 are left free of mold compound which requires a subsequent cleaning step. In case the wires are free of any resin, no cleaning step is required. As a result the tips of the wire loops 14 are not removed but instead extend beyond an upper surface of the encapsulant 15.

Fig. 2E.2 illustrates the outcome of a second variant in which the wire loops 14 are first completely embedded in the encapsulant 15 and later removed together with a surface layer of the encapsulant 15 by a removing step. Removing can be done, for example, by grinding. In particular, a low cost vertical grinding wheel can be used to reduce cost and copper smearing. Also other kinds of removing are possible like, for example, deflashing, in particular laser deflashing or chemical deflashing, sand blasting, or milling, etc. As a result the tips of the wire loops 14 are removed and upper two ends of the wire loops 14 extend up to the upper surface of the encapsulant 15. A cleaning step, e g. by copper etching, may follow.

As a further alternative to Figs. 2E.1 and 2E.2 also a combination of film assisted molding and a removing step is conceivable.

Fig. 2F illustrates the subsequent step of printing or dispensing electrical layers 16 onto the main face of the encapsulant 15 and exposed ends of the electrical connectors 14. In the present embodiment the intermediate product as of Fig. 2E.2 is used and three electrical layers 16 are deposited on an upper surface of the encapsulant 15, one of them connected with the wire loops 14 of the die pad 11, one of them connected with the wire loops 14 of the source pad 13A, one of them connected with the wire loop 14 of the gate pad 13B.

The electrical layers 16 can in particular be fabricated by printing or dispensing layers comprising a sinter paste, a hybrid sinter paste or a conductive adhesive onto an upper surface of the encapsulant 15. In the case of conductive adhesive, the layers are subsequently cured, in particular at a temperature within a range from 150°C to 280°C. The conductive adhesive may be filled with conductive particles such as Ag or Cu particles. Hybrid sinter pastes usually comprise a sinter paste and an adhesive filling its pores. In addition to the temperature curing a pressure and/or vacuum could be applied onto the sintered layer.

The electrical layers 16 can in particular be dispensed in a very efficient way by using a slit nozzle. Such a slit nozzle could be designed in a way that only one movement could already create the required layout of the electrical layers 16.

A feature of the electrical layers 16 may be that they may have large areas, which may facilitate the subsequent process of drilling through-holes through the laminate layer of a printed circuit board which will be shown later. In particular, the electrical layer 16 may comprise an extension of more than 1 mm, 2 mm, or 3 mm along at least one direction and a similar extension along another direction. More specifically, the electrical layers 16 can have an extension of more than 1 mm, 2 mm, or 3 mm along a direction along which the exposed ends of the electrical conductors 14 are spaced apart from each other. Depending on the voltage domain and the test capability a defined minimum distance is required.

Fig. 2G illustrates the subsequent step of forming of a recess 11B into a lower surface of the die carrier 11, in particular by etching. The recess 11B will serve together with the recess 11A - meanwhile filled by the encapsulant 15 - as an electrical isolation between a left hand part and a right hand part of the die carrier 11. The right hand part of the die carrier 11 will then be converted into a gate contact.

Fig. 2H illustrates the subsequent step of filling the recess 11B with an insulating material 11C thereby creating metallic substrates 11D and 11E, wherein the metallic substrate 11D now forms the drain contact and the metallic substrate 11E now forms the gate contact.

It is furthermore possible to create a roughening/treated surface at least on the top & bottom side of the semiconductor package and possibly also on the four side surfaces. The roughening could be done by artificially roughen at least part of the surfaces of the fabricated semiconductor package, in particular by laser treatment or etching, in particular of Cu, atomic layer deposition (ALD) or creation of any dendritic structures on the surfaces. In addition a plasma treatment (chemical & physical) with oxygen or argon could be mentioned. The reason for this is that for later embedding the semiconductor package into a package carrier like PCB including laminate layers, usually the laminates or pre-prepregs have only a limited adhesion property, therefore they need also a threated surface to achieve a certain reliability level which is delamination free after stress e.g. MSL / TC / HTS / etc. The artificial roughening can, for example, be carried out until the degree of roughness, measured either in RA or RMS values, is greater than 50 nm, 100 nm, 200 nm, 500 nm, 1 µm, 5 µm, 10 µm, or even more.

Fig. 3 comprises Fig. 3A and 3B and shows cross-sectional side views of examples of a semiconductor package according to the third aspect, the first example (A) corresponding to Fig. 2H, and the second example (B) corresponding to an end product of another fabrication process.

Fig. 3A shows an example of the outcome of the above described MPPL process which has already been described in detail above.

It should be added that the source pad of the semiconductor die 13 is connected directly with the electrical connectors 14 whereas the drain pad is connected to the electrical connectors 14 via the metallic substrate 11D, and the gate pad is connected to the electrical connector 14 via a bond wire and the metallic piece 11E.

Fig. 3B on the other hand shows an example of another process in which a purchased standard stamped or etched leadframe is used. In this case, a coined structure is beneficial especially for high voltage applications. All other major process steps remain untouched, except special MPPL based processes like copper etching of bottom side fill. In case of a purchased leadframe, the final package will have external connections of the package side walls, e.g. tie bars, in difference to the MPPL approach.

More specifically, Fig. 3B shows a semiconductor package 20 comprising a die carrier 21D, a semiconductor die 23 disposed on the die carrier 21D, the semiconductor die 23 comprising one or more contact pads (not shown here) on a first main face thereof, an encapsulant 25 applied at least partially to the semiconductor die 23, the encapsulant 25 embedding at least one electrical connector 24, the electrical connector 24 being connected with a contact pad or with the die carrier 21D and extending to a main face of the encapsulant 25, and at least one electrical layer 26 disposed on a main face of the encapsulant 25 and an exposed end of the at least one electrical connector 24.

The semiconductor package 20 may comprise further features similar or identical with features already described above in connection with the semiconductor package 10.

In particular the source pad of the semiconductor die 23 is connected directly with the electrical connectors 24 whereas the drain pad is connected to the electrical connectors 24 via the metallic substrate 21D, and the gate pad is connected to the electrical connector 24 via a bond wire and the metallic piece 21E.

As mentioned above, it is furthermore possible that at least the top & bottom surfaces of the semiconductor packages 10 or 20 comprise a roughening/treated surface of the semiconductor package and possibly also the four side surfaces. The roughening could be done by roughening at least part of the surfaces of the fabricated semiconductor package, in particular by laser treatment or etching, in particular of Cu, atomic layer deposition (ALD) or creation of any dendritic structures on the surfaces. In addition a plasma treatment (chemical & physical) with oxygen or argon could be mentioned. The reason for this is that for later embedding the semiconductor package into a package carrier like PCB including laminate layers, usually the laminates or prepregs do not have a good adhesion property, therefore they need also a threated surface to achieve a certain reliability level which is delamination free after stress e.g. MSL / TC / HTS / etc. The surface roughness can, for example, be so that the degree of roughness, measured either in RA or RMS values, is greater than 50 nm, 100 nm, 200 nm, 500 nm, 1 pm, 5 pm, 10 pm, or even more.

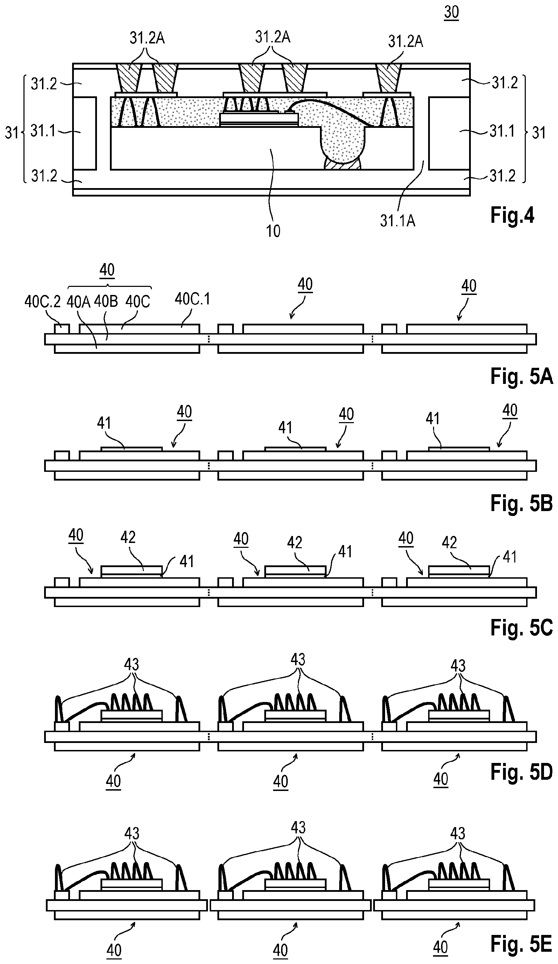

Fig. 4 shows a cross-sectional side view of an example of a semiconductor device according to the forth aspect.

More specifically, the semiconductor device 30 of Fig. 4 comprises a package carrier 31 comprising a core layer 31.1 comprising an opening 31.1A, and a semiconductor package 10 disposed in the opening 31.1A.

As shown in Fig. 4, the semiconductor package 10 is the one shown and described above in connection with Fig. 3A. However, it is also possible to use a semiconductor package 20 as described above in connection with Fig. 3B.

As further shown in Fig. 4, the package carrier 31 of the semiconductor device 30 further comprises a laminate layer 31.2 applied to the package carrier 10, the laminate layer 31.2 comprising electrical via connections 31.2A extending through the laminate layer 31.2 and reaching to the electrical layers 16 of the semiconductor package 10. The via connections 31.2A can be obtained by drilling, in particular laser drilling, via holes through the laminate layer 31.2 and subsequently filling an isolated or conductive material, in particular, copper, into the via holes. Before filling a plating process can be required, e.g. galvanic or electroless. Now it becomes apparent what a great advantage the large electrical layers 16 offer. They not only enable the creation of electrical via connections 31.2A that are relatively wide in cross-section, but also two or even more electrical via connections 31.2A arranged laterally next to each other.

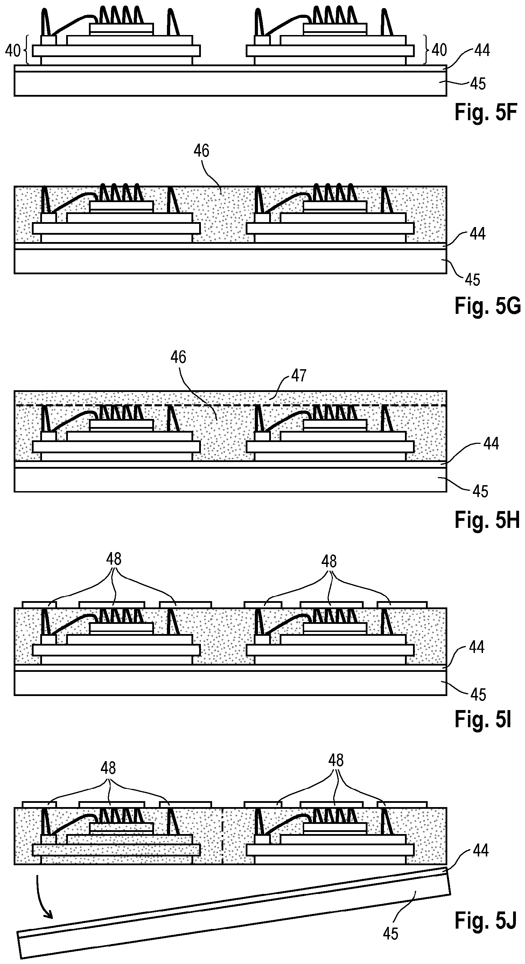

Fig. 5 comprises Fig. 5A to 5J and shows cross-sectional side views for illustrating an example of a method for fabricating a plurality of semiconductor packages according to the fifth aspect in which method the electrical connectors are applied before connecting the intermediate products to the temporal carrier.

Fig. 5A shows the provision of a panel 40 comprising a plurality of interconnected die carriers. Each one of the die carriers comprises a DCB (direct copper bond) 40 comprising a bottom Cu layer 40A, an inner ceramic layer 40B, and a top Cu layer 40C. The top Cu layer 40C comprises a first layer 40C.1 onto which the semiconductor die 42 will be disposed and a second layer 40C.2 which is to be connected to the gate pad of the semiconductor die 42. The inner ceramic layers 40B of each one of the DCBs 40 are interconnected with each other. They can also be connected to each other perpendicular to the image plane. Viewed from above or below, they can thus have a regular, in particular matrix-shaped arrangement.

Instead of DCBs also other die carriers like AMB (active metal braze) or IMS (insulated metal substrate) can be used. Also multilayer substrates are conceivable as die carriers.

Fig. 5B shows the application of a die attach material layer 41 onto an upper main face of the top Cu layer 40C of the DCB 40. The die attach material layer 41 can, for example, be comprised of a solder layer, in particular, a diffusion solder layer, a sinter paste layer, or can be part of the chip backside metallization.

Fig. 5C shows the disposing of a plurality of semiconductor dies 42 on the die attach material layers 41. The semiconductor dies 42 each comprise one or more contact pads on a first main face thereof. The semiconductor transistor dies 42 can be one or more of a vertical transistor die, a MOSFET die, an IGBT die, a SiC-MOS die, a Cool-MOS die, or an S-FET die. Furthermore the semiconductor die 13 can be one or more of a Si die, a wide bandgap semiconductor die, a SiC die, or a GaN die. The semiconductor transistor dies 42 can be configured as a discrete power transistor. A discrete power transistor is a switching device that is rated to accommodate voltages of at least 100 V (volts) and more commonly on the order of 600 V, 1200V, 2000V, 3300V or more and/or is rated to accommodate currents of at least 1A (amperes) and more commonly on the order of 10A, 50A, 100A, 1000A or more. Exemplary device types of discrete power transistors include MOSFETs (Metal Oxide Semiconductor Field Effect Transistors), IGBTs (Insulated Gate Bipolar Transistors), for example.

Fig. 5D shows the applying of at least one electrical connector 43 to each one of the contact pads of the semiconductor dies 42 and to the top Cu layer 40 C of the DCB 40. In the present embodiment the electrical connectors 43 are comprised of wire loops 43. Furthermore, in the present embodiment, four wire loops 43 are connected to the source pad of the semiconductor die 42, one wire loop 43 is connected to the first layer 40C.1 of the top Cu layer 40C of the DCB 40, and one wire loop 43 is connected to the second layer 40C.2 of the top Cu layer 40C of the DCB 40 which second layer 40C.2 is connected by a bond wire to the gate pad of the semiconductor die 42.

If two or more than two electrical connectors 43 are used as is the case with the four electrical connectors 43 connected to the source pad of the semiconductor die 42, their upper tips can be spaced from each other for a distance of more than 0.1 mm or more than 1 mm.

Fig. 5E shows the singulating of the panel into a plurality of intermediate products along separation lines between the die carriers 40. The singulating can be done by different methods, in particular by mechanical breaking, sawing, etching, or laser ablation.

The electrical connectors 43 can also comprise one or more of a single bond wire, a vertical wire, a metallic pillar, a copper pillar, or a stud bump as was already explained above in connection with the first to forth aspects of the present disclosure.

Fig. 5F shows the disposing of the intermediate products on a temporary carrier 45 via an adhesion layer 44. The temporary carrier 45 can be provided with the adhesion layer 44 on top and then the intermediate products can be placed on the adhesion layer 44 by means of a pick-and-place equipment or with a stencil.

Figs. 5G and 5H show the fabricating of a plurality of semiconductor packages by applying an encapsulant 46 at least partially to the semiconductor dies 42 and to the die carriers 40. The encapsulant 46 will be applied in such a way that the electrical connectors 43 extend at least to a main face of the encapsulant 46 of the semiconductor packages. This can be achieved by different ways. A first way is illustrated in Fig. 5G in which film-assisted molding, in particular film-assisted compression molding, is performed in a way that the tips of the wire loops 43 are left uncovered with mold compound. A second way is illustrated in Fig. 5H in which conventional compression molding is performed followed by a grinding/milling step in which an upper layer 47 of the encapsulant 46 is removed in order to release the wire loops 43. In this case the tips will be removed by the grinding/milling step and only two open ends of the wire loops will be left on an upper surface of the encapsulant 46 exposed to the outside.

Fig. 5I illustrates the subsequent step of printing or dispensing electrical layers 48 onto the main face of the encapsulant 46 and exposed ends of the electrical connectors 43. Concerning the method steps and the features of the electrical layers 48, the same applies as described above in connection with Fig. 2F with respect to the electrical layers 16.

Fig. 5J shows the separating of the semiconductor packages from each other and the subsequent removing of the temporary carrier. The separating of the semiconductor packages can, for example, be performed by mechanical dicing.

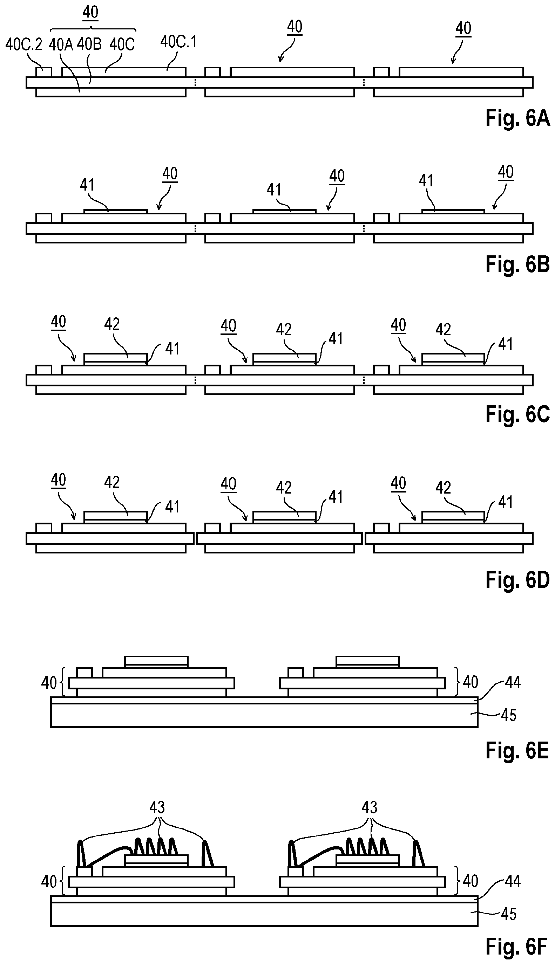

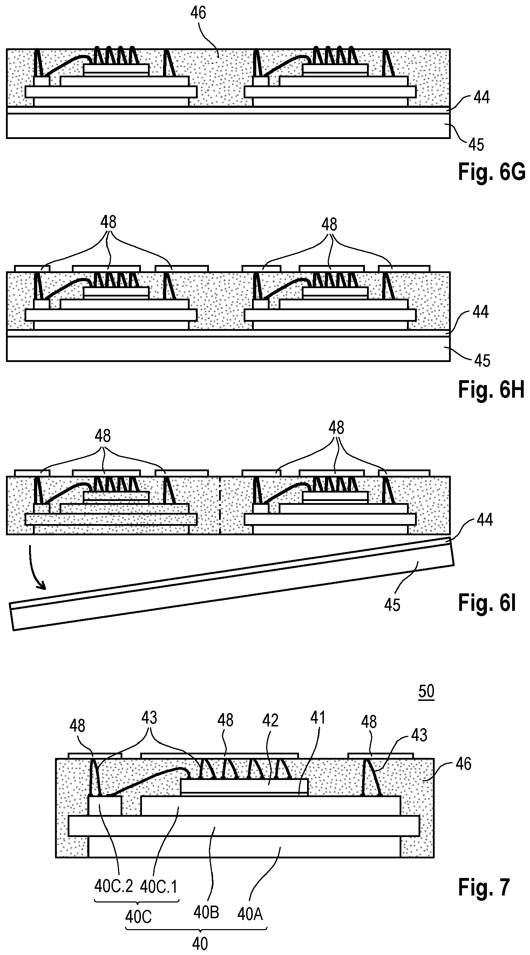

Fig. 6 comprises Fig. 6A to 6K and shows cross-sectional side views for illustrating an example of a method for fabricating a plurality of semiconductor packages according to the fifth aspect in which method the electrical connectors are applied after connecting the intermediate products to the temporal carrier.

Figs. 6A to 6C are identical with Figs. 5A to 5C so that the same reference signs are used and reference is made herewith to the above description.

Fig. 6D illustrates the singulating of the panel into a plurality of intermediate products along separation lines between the die carriers 40. The singulating can be done by different methods, in particular by mechanical breaking, sawing, etching, or laser ablation.

Fig. 6E shows the disposing of the intermediate products on a temporary carrier 45 via an adhesion layer 44. The temporary carrier 45 can be provided with the adhesion layer 44 on top and then the intermediate products can be placed on the adhesion layer 44 by means of a pick-and-place equipment or with a stencil.

Fig. 6F shows the applying of at least one electrical connector 43 to each one of the contact pads of the semiconductor dies. Concerning the method steps and the features of the electrical connectors 43, the same applies as described above in connection with Fig. 5D with respect to the electrical connectors 43.

Figs. 6G to 6I are identical with Figs. 5G, 5I, and 5J to 5C so that the same reference signs are used and reference is made herewith to the above description.

Fig. 7 shows a cross-sectional side view of a semiconductor package fabricated by either one of the method of Fig. 5 or the method of Fig. 6.

The semiconductor package 50 as shown in Fig. 7 comprises a die carrier 40 in the form of a DCB 40, a semiconductor die 42 disposed on the die carrier 40, the semiconductor die 42 comprising one or more contact pads on a first main face thereof, an encapsulant 46 applied at least partially to the semiconductor die 42, the encapsulant 46 embedding a plurality of electrical connectors 43, the electrical connectors 43 being partly connected with the contact pads and partly with the die carrier 40 and extending to a main face of the encapsulant 46, and electrical layers 48 disposed on a main face of the encapsulant 46 and to exposed ends of the electrical connectors 43.

The semiconductor package 50 is thus similar to the semiconductor packages 10 and 20 as shown and described in Figs. 3A and 3B wherein one difference is that in Fig. 7 the die carrier is comprised of a DCB 40.

The semiconductor package 50 of Fig. 7 can be embedded into a package carrier like a PCB in the same way as was shown and described in connection with Fig. 4.

To this end, an artificial surface roughening can be carried out in the same way as was described above in connection with the method of Fig. 2 and the semiconductor packages of Fig. 3.

### EXAMPLES

In the following specific Examples of the present disclosure are described.

Example 1 is a method for fabricating a semiconductor package, the method comprising providing a die carrier, disposing a semiconductor die on the die carrier, the semiconductor die comprising one or more contact pads on a first main face thereof, connecting at least one electrical connector to each one of the contact pads, applying an encapsulant at least partially to the semiconductor die and to the die carrier so that the at least one electrical connector extends to a main face of the encapsulant, and, depositing at least one electrical layer onto the main face of the encapsulant and an exposed end of the at least one electrical connector.

Example 2 is the method according to Example 1, wherein depositing the electrical layer comprises printing or dispensing a layer.

Example 3 is the method according to Example 2, further comprising printing or dispensing a sinter paste layer, a hybrid sinter paste layer, or a layer comprising a conductive paste, a glue, or a metal-resin composite paste and subsequent curing of the layer.

Example 4 is the method according to Example 2 or 3, further comprising printing or dispensing the layer by use of slit nozzle.

Example 5 is the method according to any one of the preceding Examples, wherein the at least one electrical connector comprises one or more of a bond wire, a bond wire loop, a vertical wire, a metallic pillar, a copper pillar, or a stud bump.

Example 6 is the method according to any one of the preceding Examples, wherein the at least one electrical layer is at least in part embedded in the encapsulant.

Example 7 is the method according to any one of the preceding Examples, wherein a thickness of the at least one electrical layer is in a range from 1 µm to 100 µm.

Example 8 is the method according to any one of the preceding Examples, wherein at least two electrical connectors are connected with one or more of a contact pad or with the die carrier and extending to a main face of the encapsulant, wherein the exposed ends of the electrical connectors are spaced from each other for more than 0.1 mm or more than 1 mm.

Example 9 is the method according to any one of the preceding Examples, wherein the at least one electrical layer comprises an extension of more than 1 mm, 2 mm or 3 mm along at least one direction.

Example 10 is the method according to Examples 8 and 9, wherein the at least one electrical layer has an extension of more than 1 mm, 2 mm or 3 mm along a direction along which the exposed ends of the electrical conductors are spaced apart from each other.

Example 11 is the method according to any one of the preceding Examples, wherein the semiconductor die comprises a vertical structure comprising a source pad on the first main face and a drain pad on a second main face opposite to the first main face, wherein the electrical connectors comprise first and second electrical connectors, wherein a first electrical connector is connected with the source pad and a second electrical connector is connected with the die carrier.

Example 12 is the method according to Example 12. The method according to Examples 10, wherein the semiconductor die comprises a gate pad on the first main face, wherein the electrical connectors comprise a third electrical connector which is connected with the gate pad.

Example 13 is the method according to any one of the preceding Examples, further comprising artificially roughening at least part of the surfaces of the fabricated semiconductor package.

Example 14 is the method according to any one of the preceding Examples, wherein the die carrier is one of a direct copper bond (DCB), an active metal braze (AMB), or an insulated metal substrate (IMS).

Example 15 is a method for fabricating a plurality of semiconductor packages, comprising providing a panel comprising a plurality of interconnected die carriers, disposing a plurality of semiconductor dies on the die carriers, the semiconductor die each comprising one or more contact pads on a first main face thereof, connecting at least one electrical connector to each one of the contact pads of the semiconductor dies, singulating the panel into a plurality of intermediate products along separation lines between the die carriers, disposing the intermediate products on a temporary carrier, fabricating a plurality of semiconductor packages by applying an encapsulant at least partially to the semiconductor dies and to the die carriers so that the at least one electrical connector extends to a main face of the encapsulant of the semiconductor packages, depositing at least one electrical layer onto the main face of the encapsulant and an exposed end of the at least one electrical connector of the semiconductor packages, separating the semiconductor packages from each other, and removing the temporary carrier.

Example 16 is the method according to Example and any one of the features of Examples 1 to 14.

Example 17 is a method for fabricating a semiconductor device, the method comprising providing a package carrier comprising a core layer comprising an opening; and disposing the semiconductor package fabricated according to any one of the preceding Examples in the opening.

Example 18 is the method according to Example 17, further comprising applying a laminate layer to the package carrier; drilling holes through the laminate layer to the electrical layers; and filling the through holes with an electrically conductive material.

Example 19 is a semiconductor package, comprising a die carrier, a semiconductor die disposed on the die carrier, the semiconductor die comprising one or more contact pads on a first main face thereof; an encapsulant applied at least partially to the semiconductor die, the encapsulant embedding at least one electrical connector, the electrical connector being connected with a contact pad or with the die carrier and extending to a main face of the encapsulant; and at least one electrical layer disposed on a main face of the encapsulant and an exposed end of the at least one electrical connector.

Example 20 is the semiconductor package according to Example 19, wherein the electrical layer comprises one or more of a sinter paste, a hybrid sinter paste, a solder paste, a conductive paste, a metal-resin composite paste, or a glue.

Example 21 is the semiconductor package according to Example 19 or 20, wherein the at least one electrical connector comprises one or more of a bond wire, a bond wire loop, a vertical wire, a metallic pillar, a copper pillar, or a stud bump.

Example 22 is the semiconductor package according to any one of Examples 19 to 21, wherein the at least one electrical layer is at least in part embedded in the encapsulant.

Example 23 is the semiconductor package according to any one of Examples, wherein a thickness of the at least one electrical layer is in a range from 1 µm to 100 µm.

Example 24 is the semiconductor package according to any one of Examples 19 to 23, wherein at least two electrical connectors are connected with one or more of a contact pad or with the die carrier and extending to a main face of the encapsulant, wherein the exposed ends of the electrical connectors are spaced from each other for more than 0.5 mm or more than 1 mm.

Example 25 is the semiconductor package according to any one of Examples 19 to 24, wherein the at least one electrical layer comprises an extension of more than 1 mm, 2 mm or 3 mm along at least one direction.

Example 26 is the semiconductor package according to Example 25, wherein the at least one electrical layer has an extension of more than 1 mm, 2 mm or 3 mm along a direction along which the exposed ends of the electrical conductors are spaced apart from each other.

Example 27 is the semiconductor package according to any one of Examples 19 to 26, wherein the semiconductor die comprises a vertical structure comprising a source pad on the first main face and a drain pad on a second main face opposite to the first main face, wherein the electrical connectors comprise first and second electrical connectors, wherein a first electrical connector is connected with the source pad and a second electrical connector is connected with the die carrier.

Example 28 is the semiconductor package according to Example 26 or 27, wherein the semiconductor die comprises a gate pad on the first main face, wherein the electrical connectors comprise a third electrical connector which is connected with the gate pad.

Example 29 is the semiconductor package according to any one of Examples 19 to 28, wherein the die carrier is one of a direct copper bond (DCB), an active metal braze (AMB), or an insulated metal substrate (IMS).

Example 30 is a semiconductor device, comprising a package carrier comprising a core layer comprising an opening, and a semiconductor package according to any one of claims 19 to 29 disposed in the opening (31.1A).

Example 31 is the semiconductor device according to Example 30, further comprising a laminate layer applied to the package carrier, the laminate layer comprising electrical via connections to the electrical layers of the semiconductor package.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method (100) for fabricating a semiconductor package, the method comprising
- providing a die carrier (110);
- disposing a semiconductor die on the die carrier, the semiconductor die comprising one or more contact pads on a first main face thereof (120);
- connecting at least one electrical connector to each one of the contact pads (130);
- applying an encapsulant at least partially to the semiconductor die and to the die carrier so that the at least one electrical connector extends to a main face of the encapsulant (140); and
- depositing at least one electrical layer onto the main face of the encapsulant and an exposed end of the at least one electrical connector (150).

2. The method according to claim 1, wherein
depositing the electrical layer comprises printing or dispensing a layer.

3. The method according to claim 2, further comprising printing or dispensing a sinter paste layer, a hybrid sinter paste layer, or a layer comprising a conductive paste, a glue, or a metal-resin composite paste and subsequent curing of the layer.

4. The method according to claim 2 or 3, further comprising printing or dispensing the layer by use of slit nozzle.

5. The method according to any one of the preceding claims, wherein
the at least one electrical connector comprises one or more of a bond wire, a bond wire loop, a vertical wire, a metallic pillar, a copper pillar, or a stud bump.

6. The method according to any one of the preceding claims, wherein
the at least one electrical layer is at least in part embedded in the encapsulant.

7. The method according to any one of the preceding claims, wherein
a thickness of the at least one electrical layer is in a range from 1 µm to 100 µm.

8. The method according to any one of the preceding claims, wherein
at least two electrical connectors are connected with one or more of a contact pad or with the die carrier and extending to a main face of the encapsulant, wherein
the exposed ends of the electrical connectors are spaced from each other for more than 0.1 mm or more than 1 mm.

9. The method according to any one of the preceding claims, wherein
the at least one electrical layer comprises an extension of more than 1 mm, 2 mm or 3 mm along at least one direction.

10. The method according to claims 8 and 9, wherein
the at least one electrical layer has an extension of more than 1 mm, 2 mm or 3 mm along a direction along which the exposed ends of the electrical conductors are spaced apart from each other.

11. The method according to any one of the preceding claims, wherein
the semiconductor die comprises a vertical structure comprising a source pad on the first main face and a drain pad on a second main face opposite to the first main face, wherein the electrical connectors comprise first and second electrical connectors, wherein a first electrical connector is connected with the source pad and a second electrical connector is connected with the die carrier.

12. The method according to claim 11, wherein
the semiconductor die comprises a gate pad on the first main face, wherein
the electrical connectors comprise a third electrical connector which is connected with the gate pad.

13. The method according to any one of the preceding claims, further comprising
artificially roughening at least part of the surfaces of the fabricated semiconductor package.

14. The method according to any one of the preceding claims, wherein
the die carrier is one of a direct copper bond (DCB), an active metal braze (AMB), or an insulated metal substrate (IMS) .

15. A method (200) for fabricating a plurality of semiconductor packages, comprising
- providing a panel comprising a plurality of interconnected die carriers (210);
- disposing a plurality of semiconductor dies on the die carriers, the semiconductor die each comprising one or more contact pads on a first main face thereof (220);
- connecting at least one electrical connector to each one of the contact pads of the semiconductor dies (230);
- singulating the panel into a plurality of intermediate products along separation lines between the die carriers (240) ;
- disposing the intermediate products on a temporary carrier (250) ;
- fabricating a plurality of semiconductor packages by applying an encapsulant at least partially to the semiconductor dies and to the die carriers so that the at least one electrical connector extends to a main face of the encapsulant of the semiconductor packages (260);
- depositing at least one electrical layer onto the main face of the encapsulant and an exposed end of the at least one electrical connector of the semiconductor packages (270);
- separating the semiconductor packages from each other (280); and
- removing the temporary carrier (290).

16. The method according to claim 15 and any one of the features of claims 1 to 14.

17. A method for fabricating a semiconductor device, the method comprising
providing a package carrier comprising a core layer comprising an opening; and
disposing the semiconductor package fabricated according to any one of the preceding claims in the opening.

18. A method according to claim 17, further comprising applying a laminate layer to the package carrier;
drilling holes through the laminate layer to the electrical layers; and
filling the through holes with an electrically conductive material.

19. A semiconductor package (10; 20; 50), comprising
- a die carrier (11D; 21D);
- a semiconductor die (13; 23; 42) disposed on the die carrier (11D; 21D; 40), the semiconductor die (13; 23; 42) comprising one or more contact pads (13A, 13B) on a first main face thereof;
- an encapsulant (15; 25; 46) applied at least partially to the semiconductor die (13; 23; 42), the encapsulant (15; 25; 46) embedding at least one electrical connector (14; 24), the electrical connector (14; 24; 43) being connected with a contact pad (13A, 13B) or with the die carrier (11D; 21D; 40) and extending to a main face of the encapsulant (15; 25; 46); and
- at least one electrical layer (16; 26; 48) disposed on a main face of the encapsulant (15; 25; 46) and an exposed end of the at least one electrical connector (14; 24; 43).

20. The semiconductor package (10, 20; 50) according to claim 19, wherein
the electrical layer (16; 26; 48) comprises one or more of a sinter paste, a hybrid sinter paste, a solder paste, a conductive paste, a metal-resin composite paste, or a glue.

21. The semiconductor package (10; 20; 50) according to claim 19 or 20, wherein
the at least one electrical connector (14; 24; 43) comprises one or more of a bond wire, a bond wire loop, a vertical wire, a metallic pillar, a copper pillar, or a stud bump.

22. The semiconductor package (10; 20; 50) according to any one of claims 19 to 21, wherein
the at least one electrical layer (16; 26; 48) is at least in part embedded in the encapsulant (15; 25; 46).

23. The semiconductor package (10; 20; 50) according to any one of claims 19 to 22, wherein
a thickness of the at least one electrical layer (16; 26; 48) is in a range from 1 µm to 100 µm.

24. The semiconductor package (10; 20; 50) according to any one of claims 19 to 23, wherein
at least two electrical connectors (14; 24; 43) are connected with one or more of a contact pad (13A, 13B) or with the die carrier (11D; 21D; 40) and extending to a main face of the encapsulant (15; 25; 46), wherein
the exposed ends of the electrical connectors (14; 24; 43) are spaced from each other for more than 0.5 mm or more than 1 mm.

25. The semiconductor package (10; 20; 50) according to any one of claims 19 to 24, wherein
the at least one electrical layer (16; 26; 43) comprises an extension of more than 1 mm, 2 mm or 3 mm along at least one direction.

26. The semiconductor package (10; 20; 50) according to claim 25, wherein
the at least one electrical layer (16; 26; 43) has an extension of more than 1 mm, 2 mm or 3 mm along a direction along which the exposed ends of the electrical conductors are spaced apart from each other.

27. The semiconductor package (10; 20; 50) according to any one of claims 19 to 26, wherein
the semiconductor die (13; 23; 42) comprises a vertical structure comprising a source pad (13A) on the first main face and a drain pad on a second main face opposite to the first main face, wherein
the electrical connectors (14; 24; 43) comprise first and second electrical connectors, wherein a first electrical connector (14; 24; 43) is connected with the source pad (13A) and a second electrical connector (14; 24; 43) is connected with the die carrier (11D; 21D).

28. The semiconductor package (10; 20; 50) according to claim 26 or 27, wherein
the semiconductor die (13; 23; 42) comprises a gate pad (13B) on the first main face, wherein
the electrical connectors (14; 24; 43) comprise a third electrical connector (14; 24; 43) which is connected with the gate pad (11B).

29. The semiconductor package (50) according to any one of claims 19 to 28, wherein
the die carrier (40) is one of a direct copper bond (DCB) (40), an active metal braze (AMB), or an insulated metal substrate (IMS).

30. A semiconductor device (30), comprising
a package carrier (31) comprising a core layer (31.1) comprising an opening (31.1A); and
a semiconductor package (10; 20; 50) according to any one of claims 19 to 29 disposed in the opening (31.1A).

31. The semiconductor device (30) according to claim 30, further comprising
a laminate layer (31.2) applied to the package carrier (31), the laminate layer (31.2) comprising electrical via connections (31.2A) to the electrical layers (16; 26; 48) of the semiconductor package (10; 20; 50).
